(19) **Europäisches Patentamt / European Patent Office / Office européen des brevets**

(11) **EP 2 088 634 A1**

(12) # EUROPEAN PATENT APPLICATION
published in accordance with Art. 153(4) EPC

(43) Date of publication:
**12.08.2009 Bulletin 2009/33**

(21) Application number: **07830122.3**

(22) Date of filing: **12.10.2007**

(51) Int Cl.:
*H01L 35/22* (2006.01)          *C04B 35/00* (2006.01)
*H01L 35/34* (2006.01)

(86) International application number:
**PCT/JP2007/070388**

(87) International publication number:
**WO 2008/047885 (24.04.2008 Gazette 2008/17)**

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **17.10.2006 JP 2006282293**
**12.04.2007 JP 2007104642**

(71) Applicant: **Sumitomo Chemical Company, Limited Tokyo 104-8260 (JP)**

(72) Inventors:
• **UCHIDA, Yoshio**
  **Ibaraki (JP)**
• **TOHMA, Tetsuro**
  **Ehime (JP)**
• **SADAOKA, Kazuo**
  **Osaka (JP)**

(74) Representative: **Hart-Davis, Jason et al**
**Cabinet Beau de Loménie,**
**158, rue de l'Université**
**75340 Paris Cedex 07 (FR)**

(54) **THERMO-ELECTRIC CONVERTING MATERIAL, PROCESS FOR PRODUCING THE SAME, THERMO-ELECTRIC CONVERTING ELEMENT, AND METHOD OF HEIGHTENING STRENGTH OF THERMO-ELECTRIC CONVERTING MATERIAL**

(57)    The present invention provides a thermoelectric conversion material having an excellent thermoelectric conversion property and excellent in mechanical strength, a method for producing the same, and a thermoelectric conversion device using the same. A thermoelectric conversion material comprising an oxide for thermoelectric conversion material and an inorganic substance wherein the inorganic substance does not react with the oxide for thermoelectric conversion material under conditions of pressure: 950 hPa to 1050 hPa and temperature: 900°C. A method for producing a thermoelectric conversion material comprises the steps (a1) and (a2): (a1) forming a mixture of an oxide for thermoelectric conversion material and an inorganic substance to obtain a green body, (a2) sintering the green body in air at 800°C to 1700°C.

Fig. 1

# EP 2 088 634 A1

## Description

### TECHNICAL FIELD

The present invention relates to a thermoelectric conversion material, a method for producing the same, a thermoelectric conversion device and a method of improving the strength of a thermoelectric conversion material.

### BACKGROUND ART

Thermoelectric conversion power generation is power generation of converting thermal energy into electric energy, utilizing Seebeck effect by which thermal electromotive force is generated by applying a temperature difference betwenn thermoelectric conversion materials. Thermoelectric conversion power generation is expected as environment-conservative power generation since it is capable of utilizing earth's heat or exhaust heat such as heat from incinerators as a thermal energy.

An efficiency of converting thermal energy into electric energy of the thermoelectric conversion material (hereinafter, referred to as "energy conversion efficiency") depends on figure of merit (Z) of the thermoelectric conversion material. The figure of merit (Z) is determined according to the equation (1) using the Seebeck coefficient ($\alpha$), electric conductivity ($\sigma$) and thermal conductivity ($\kappa$) of the thermoelectric conversion material.

$$Z = \alpha^2 \times \sigma / \kappa \quad (1)$$

If a thermoelectric conversion material having large figure of merit (Z) is used, a thermoelectric conversion device of excellent energy conversion efficiency is obtained. $\alpha^2 \times \sigma$ in the equation (1) is called a power factor (PF), and larger this value of a thermoelectric conversion material, output becomes higher per unit temperature of a thermoelectric conversion device.

The thermoelectric conversion material includes a p-type thermoelectric conversion material having a positive Seebeck coefficient and an n-type thermoelectric conversion material having a negative Seebeck coefficient. Usually, a thermoelectric conversion device having a p-type thermoelectric conversion material and an n-type thermoelectric conversion material connected electrically serially is used, in thermoelectric conversion power generation. The energy conversion efficiency of the thermoelectric conversion device depends on the figure of merit (Z) of the p-type thermoelectric conversion material and the n-type thermoelectric conversion material. For obtaining a thermoelectric conversion device excellent in energy conversion efficiency, p-type thermoelectric conversion materials and n-type thermoelectric conversion materials having a large figure of merit (Z) are required.

Conventionally, as an oxide for n-type thermoelectric conversion material, there are suggested $SrTiO_3$ (JP-A 8-231223, p.2-3) and $CaMnO_3$ (JP-A 2003-142742, p.2-3), having a perovskite crystal structure. As an oxide for p-type thermoelectric conversion material, there are suggested $NaCo_2O_4$ (JP-A 9-321346, p.5-6), $Ca_3Co_4O_9$ (JP-A 2001-64021, p.2-3), oxides represented by the formula: $CuO_{2+\delta}$ (Oxide Thermoelectrics, 2002 (ISBN 81-7736-100-7), p.213-234) and oxides represented by $RBa_2Cu_3O_{7-\delta}$ (JP-A 2001-512910, p.2-8).

However, a conventional thermoelectric conversion material obtained by sintering an oxide for thermoelectric conversion material has insufficient mechanical strength and, manifests occurrence of crack in application of pressure in its processing step in some cases.

### DISCLOSURE OF THE INVENTION

The present invention has an object of providing a thermoelectric conversion material having an excellent thermoelectric conversion property such as PF and excellent in mechanical strength, a method for producing the same, and a thermoelectric conversion device using the same. Anther object of the present invention is to provide a method of improving the strength of a thermoelectric conversion material.

The present inventors have variously investigated thermoelectric conversion materials and resultantly completed the present invention.

That is, the present invention provides the following <1> to <14>.

<1> A thermoelectric conversion material comprising an oxide for thermoelectric conversion material and an inorganic substance wherein the inorganic substance does not react with the oxide for thermoelectric conversion material under conditions of pressure: 950 hPa to 1050 hPa and temperature: 900°C.

<2> A thermoelectric conversion material comprising an oxide for thermoelectric conversion material and an inorganic substance wherein the material does not comprise a reaction product of the oxide for thermoelectric conversion material and the inorganic substance

<3> The thermoelectric conversion material according to <1> or <2> wherein the oxide for thermoelectric conversion material is a manganese oxide.

<4> The thermoelectric conversion material according to <3> wherein the oxide for thermoelectric conversion material is a calcium manganese oxide.

<5> The thermoelectric conversion material according to <1> or <2> wherein the oxide for thermoelectric conversion material has a perovskite crystal structure or layered perovskite crystal structure.

<6> The Thermoelectric conversion material according to <1> or <2> wherein the inorganic substance is an oxides.

<7> The thermoelectric conversion material according to <6> wherein the inorganic substance is at least one selected from among nickel oxide, copper oxide and zinc oxide.

<8> The thermoelectric conversion material according to <1> or <2> wherein the amount of the inorganic substance is 1 to 60 mol% with respect to the thermoelectric conversion material.

<9> The thermoelectric conversion material according to <1> or <2> wherein the form of the material is sintered body and the sintered body has a relative density of not less than 70%.

<10> A thermoelectric conversion device comprising the thermoelectric conversion material as described in <1> or <2>.

<11> A method for producing a thermoelectric conversion material comprising the steps of (a1) and (a2):

(a1) forming a mixture of an oxide for thermoelectric conversion material and an inorganic substance to obtain a green body,
(a2) sintering the green body in air at 800°C to 1700°C.

<12> The method according to <11>, further comprising a step (a0) selected from among (i) and (ii), for preparing a mixture an oxide for thermoelectric conversion material and an inorganic substance:

(i) calcinig a mixture of a raw material containing a metal element which is converted by calcination into an oxide for thermoelectric conversion material, and an inorganic substance,
(ii) calcining a raw material containing a metal element which is converted by calcination into an oxide for thermoelectric conversion material, and mixing the resultant calcined body and an inorganic substance.

<13> The method according to <12> wherein the calcination is carried out in air at 600°C to 1500°C.

<14> A method of improving the strength of a thermoelectric conversion material, comprising the steps of (b1) and (b2):

(b1) forming a mixture of a thermoelectric conversion material and an inorganic substance to obtain a green body,
(b2) sintering the green body in air at 800°C to 1700°C.

BRIEF EXPLANATION OF DRAWINGS

Fig. 1 shows an X-ray diffraction pattern of a thermally treated body in Example 1.
Fig. 2 shows an X-ray diffraction pattern of a sintered body 4 in Comparative Example 1.
Fig. 3 shows an X-ray diffraction pattern of a thermally treated body in Comparative Example 1.
Fig. 4 shows an X-ray diffraction pattern of a thermally treated body in Comparative Example 2.
Fig. 5 shows an X-ray diffraction pattern of NiO used in Examples 1 to 3.
Fig. 6 shows an X-ray diffraction pattern of titanium oxide used in Comparative Example 2.
Fig. 7 shows an X-ray diffraction pattern of copper oxide used in Examples 4 to 6.
Fig. 8 shows an X-ray diffraction pattern of a thermally treated body in Example 4.
Fig. 9 shows an X-ray diffraction pattern of zinc oxide used in Example 7.
Fig. 10 shows an X-ray diffraction pattern of a thermally treated body in Example 7.
Fig. 11 shows an X-ray diffraction pattern of a thermally treated body in Example 8.

MODES FOR CARRYING OUT THE INVENTION

**Thermoelectric conversion material, method for producing the same**

The thermoelectric conversion material comprises an oxide for thermoelectric conversion material and an inorganic substance.

The oxide for thermoelectric conversion material includes oxides for p-type thermoelectric conversion material and oxides for n-type thermoelectric conversion material. Examples of the oxide for p-type thermoelectric conversion material include $NaCo_2O_4$, $Ca_3Co_4O_9$, Li-doped NiO, $ACuO_{2+\delta}$ (A is at least one selected from among Y, alkaline earth metal elements and rare earth metal elements, and 5 is not less than 0 and not more than 1.), $RBa_2Cu_3O_{7-\delta}$ (R is at least one selected from among Y, Ce, Nd, Pm, Sm, Eu, Gd, Tb, Dy, Ho, Er, Tm, Yb and Lu , and $\delta$ is not less than 0 and not more than 1.), $(Ca, Sr)_{14}Cu_{24}O_{41}$, $(La, Sr)_2ZnO_4$ and $SrFeO_3$. Examples of the oxide for n-type thermoelectric conversion material include $SrTiO_3$, manganese oxides, $LaNiO_3$, $La_{n+1}Ni_nO_{3n+1}$ (n is an integer of 1 to 10), $(ZnO)_mIn_2O_3$ (m is an integer of 1 to 19), $(ZnO)_mInGaO_3$ (m is an integer of 1 to 19) and $Ae_xTi_8O_{16}$ (Ae is an alkaline earth metal, and x is not less than 0.8 and not more than 2.). The oxide for thermoelectric conversion material is preferably a manganese oxide such as $CaMnO_3$, $Ca_{n+1}Mn_nO_{3n+1}$ (n is an integer of 1 to 10), $CaMn_7O_{12}$, $Mn_3O_4$, $MnO_2$ and $CuMnO_2$, more preferably a calcium manganese oxide. The oxide for thermoelectric conversion material has preferably a perovskite crystal structure or layered perovskite crystal structure. Examples of the oxide for thermoelectric conversion material having a perovskite crystal structure include oxides composed mainly of $CaMnO_3$, and a part of Ca and/or Mn may be substituted by a heterogeneous element in a range not deteriorating the effect of the present invention. Examples of the element for substituting for Ca include Mg, Sr, Ba, Sc, Y, La, Ce, Pr, Nd, Pm, Sm, Eu, Gd, Tb, Dy, Ho, Er, Tm, Yb, Lu, Bi, Sn, In, Pb, preferably Mg, Sr, Ba. These may be used singly or in combination with another or more. Examples of the element for substituting for Mn include Ru, Nb, Mo, W, Ta. These may be used singly or in combination with another or more. An oxide for thermoelectric conversion material having a perovskite crystal structure in which a part of Ca and/or Mn is substituted by a heterogeneous element shows a high thermoelectric conversion property in some cases. Examples of the oxide for thermoelectric conversion material having a layered perovskite crystal structure include oxides composed mainly of a compound of the formula (1):

$$Ca_{n+1}Mn_nO_{3n+1} \qquad (1)$$

n is an integer of 1 to 10, and a part of Ca and/or Mn may be substituted by a heterogeneous element in a range not deteriorating the effect of the present invention. Examples of the element for substituting for Ca include Mg, Sr, Ba, Sc, Y, La, Ce, Pr, Nd, Pm, Sm, Eu, Gd, Tb, Dy, Ho, Er, Tm, Yb, Lu, Bi, Sn, In, Pb, preferably Mg, Sr, Ba. These may be used singly or in combination with another or more. Examples of the element for substituting for Mn include Ru, Nb, Mo, W, Ta. These may be used singly or in combination with another or more. Also the oxide for thermoelectric conversion material having a layered perovskite crystal structure in which a part of Ca and/or Mn is substituted by a heterogeneous element shows a high thermoelectric conversion property in some cases.

The inorganic substance may advantageously be one which does not react with the oxide for thermoelectric conversion material under thermal treatment conditions of pressure: 950 hPa to 1050 hPa and temperature: 900°C. The pressure is usually atmospheric pressure, and operations of pressurization and pressure reduction are not necessarily required. The temperature is usually a set temperature in a thermal treatment apparatus, and the temperature of a mixture to be thermally treated may be within the range of set temperature $\pm$ 20°C. Of thermal treatment conditions, the atmosphere may vary depending on the kind of the oxide for thermoelectric conversion material. If the oxide for thermoelectric conversion material is stable under an air atmosphere of the above-described pressure and temperature, the thermal treatment may be carried out under an air atmosphere. If it is stable under an oxygen atmosphere, the thermal treatment may be carried out under an oxygen atmosphere. If it is stable under an inert atmosphere, the thermal treatment may be carried out under an inert atmosphere. If it is stable under a reduction atmosphere, the thermal treatment may be carried out under a reduction atmosphere. In this specification, "an inorganic substance does not react with an oxide for thermoelectric conversion material" means that when a mixture of an oxide for thermoelectric conversion material and an inorganic substance is thermally treated under the above-described condition, the resultant thermally treated body manifests, in a powder X-ray diffraction pattern, no presence of a diffraction peak (diffraction peak A) which is neither a diffraction peak ascribable to the crystal structure of the oxide for thermoelectric conversion material nor a diffraction peak ascribable to the crystal structure of the inorganic substance, or, even if the diffraction peak A is present, when the intensity of a diffraction peak showing maximum intensity (diffraction peak B) is 100, the intensity of the diffraction peak A is less than 1. The powder X-ray diffraction pattern is advantageously determined by powder X-ray diffractometry (radiation source: $CuK\alpha$, diffraction angle $2\theta$: 10° to 60°) of the thermally treated body. The inorganic substance may be advantageously one which does not react with the oxide for thermoelectric conversion material under thermal treatment conditions of pressure: 950 hPa to 1050 hPa and temperature: 900°C., and may be appropriately selected depending on the oxide for thermoelectric conversion material. Examples of the inorganic substance include non-oxide materials such as carbides (silicon carbide, titanium carbide, boron carbide) and nitrides (silicon nitride, boron nitride), and oxide materials such as mixed oxides (binary oxides, ternary oxide), simple oxides (unitary oxides) and acid nitrides, preferably oxide materials. The oxide materials are preferably simple oxides.

The simple oxides include titanium oxide, manganese oxide, cobalt oxide, nickel oxide, copper oxide, zinc oxide, zirconium oxide, niobium oxide, molybdenum oxide, aluminum oxide, silicon oxide, gallium oxide, indium oxide and tin oxide. For example, when the oxide for thermoelectric conversion material is a manganese oxide, the inorganic substance is preferably nickel oxide, copper oxide, zinc oxide, more preferably nickel oxide, copper oxide. These may be used singly or in combination with another or more. When, the inorganic substance is zinc oxide, a part of zinc may be substituted by a heterogeneous element, and examples of the element for substituting for zinc include Mg, Ca, Sr, Ba, Sc, Y, La, Ce, Pr, Nd, Sm, Eu, Gd, Tb, Dy, Ho, Er, Tm, Yb, Lu, Al, Ga, In, Ge, Sn, Ti, Zr, Hf, V, Nb, Ta, Cr, Mo, W, Mn, Fe, Co, Ni, Cu, Ru, preferably Y, La, Ce, Pr, Nd, Sm, Eu, Gd, Tb, Dy, Ho, Er, Tm, Yb, Lu, Al, Ga, In. These may be used singly or in combination with another or more. The amount of substitution is usually 0.01 mol% to 10 mol% with respect to zinc.

The combination of an oxide for thermoelectric conversion material and an inorganic substance includes Li-doped NiO/zinc oxide, Li-doped NiO/copper oxide, $(La, Sr)_2ZnO_4$/copper oxide, $CaMnO_3$/nickel oxide, $CaMnO_3$/copper oxide, $CaMnO_3$/zinc oxide, $Ca_{n+1}Mn_nO_{3n+1}$ (n is an integer of 1 to 10)/nickel oxide, $Ca_{n+1}Mn_nO_{3n+1}$ (n is an integer of 1 to 10)/copper oxide, $Ca_{n+1}Mn_nO_{3n+1}$ (n is an integer of 1 to 10)/zinc oxide, $(ZnO)_mIn_2O_3$ (m is an integer of 1 to 19)/copper oxide or $(ZnO)_mInGaO_3$ (m is an integer of 1 to 19)/copper oxide. The amount of the inorganic substance is usually 1 to 60 mol% with respect to the thermoelectric conversion material. The preferable amount of the inorganic substance varies depending on the combination of oxide for thermoelectric conversion material/inorganic substance. For example, when the thermoelectric conversion material contains $CaMnO_3$ and NiO, the amount of NiO is preferably 20 to 50 mol%, more preferably 25 to 40 mol% with respect to the thermoelectric conversion material from the standpoint of improving mechanical strength and thermoelectric property. When the thermoelectric conversion material contains $CaMnO_3$, CuO, the amount of CuO is preferably 1 to 50 mol%, more preferably 5 to 40 mol%, further preferably 2 to 20 mol% with respect to the thermoelectric conversion material. When the thermoelectric conversion material contains $CaMnO_3$, ZnO, the amount of ZnO is preferably 20 to 50 mol%, more preferably 25 to 40 mol% with respect to the thermoelectric conversion material.

Thermoelectric conversion material preferably has both a diffraction peak ascribable to the crystal structure of the oxide for thermoelectric conversion materials and a diffraction peak ascribable to the crystal structure of the inorganic substance, in a powder X-ray diffraction pattern. Further, it is preferable that the thermoelectric conversion material contains no reaction product of the oxide for thermoelectric conversion material and the inorganic substance. The powder X-ray diffraction pattern may be advantageously determined by powder X-ray diffractometry (radiation source: $CuK\alpha$, diffraction angle $2\theta$: 10° to 60°).

The thermoelectric conversion material usually has a form of sintered body. The thermoelectric conversion material is preferably a dense sintered body like an oriented sintered body from the standpoint of further increasing electric conductivity ($\sigma$). The thermoelectric conversion material has a relative density of preferably not less than 70%, more preferably not less than 80%, further preferably not less than 90%. The relative density may be advantageously determined according to the following equation using the formula weight $\alpha$ of the oxide for thermoelectric conversion material, the true density (specific gravity) $A(g/cm^3)$ of the oxide for thermoelectric conversion material, the formula weight $\beta$ of the inorganic substance, the true density (specific gravity) $B(g/cm^3)$ of the inorganic substance, the sintering density $C$ $(g/cm^3)$ of the thermoelectric conversion material and the amount $x$ (mol%) of the inorganic substance in the thermoelectric conversion material.

$$\text{Relative density (\%)} = C/[\{\alpha \times (100-x)/100 + \beta \times x/100\}/\{\alpha \times (100-x)/A + \beta \times x/B\}] \times 100$$

Regarding the thermoelectric conversion material as a sintered body, it is advantageous that the shape and dimension thereof are appropriate as a thermoelectric conversion device, and the shape is, for example, plate, circular cylinder or rectangular cylinder.

The thermoelectric conversion material has an excellent thermoelectric conversion property and excellent in mechanical strength. The thermoelectric conversion material shows also an excellent thermal shock property.

The thermoelectric conversion material may be advantageously produced, for example, by a method including a step (a1) of forming a mixture of an oxide for thermoelectric conversion material and an inorganic substance to obtain a green body, and a step (a2) of sintering the green body. In this production method, the oxide for thermoelectric conversion material and the inorganic substance are the same as those explained for the above-described thermoelectric conversion material, and it has a shape suitable for forming. Its form is usually powder. The mixture of an oxide for thermoelectric conversion material and an inorganic substance may be advantageously prepared, for example, by a method include a step (a0) selected from among the following (i) and (ii). The step (i) is a step in which a mixture of a raw material containing a metal element which is converted by calcination into an oxide for thermoelectric conversion material, and an inorganic substance is calcined, and when described in detail, a raw material containing a metal element which is converted by calcination into an oxide for thermoelectric conversion material is weighed so as to given composition, and a mixture of this and an inorganic substance is calcined. The step (ii) is a step in which a raw material containing a metal element which is converted by calcination into an oxide for thermoelectric conversion material is calcined, and the resultant calcined body and an inorganic substance are mixed, and when described in detail, a raw material containing a metal element which is converted by calcination into an oxide for thermoelectric conversion material is weighed so as to given composition and calcined, and the resultant calcined body and an inorganic substance are mixed. Examples of the raw material containing a metal element include compounds which are decomposed and/or oxidized at high temperature to become oxides such as hydroxides, carbonates, nitrates, halides, sulfates and organic acid salts, or oxides. The raw metal containing a metal element may be a metal. For example, when $CaMnO_3$ is used as the oxide for thermoelectric conversion material, the compound containing Ca includes carbonates, sulfates and hydroxides, preferably carbonates. The compound containing Mn includes manganese monoxide, manganese dioxide, dimanganese trioxide, trimanganese tetraoxide, manganese nitrate, manganese acetate, preferably, manganese dioxide. The mixing may be carried out either in dry mode or wet mode. The mixing is preferably carried out by a method by which a uniform mixture containing a compound containing a metal element is obtained, and it is preferable that the mixing is carried out using, for example, ball mill, V-shape mixer, vibration mill, attritor, dyno mill, dynamic mill. In mixing, a mixture may be pulverized. The calcination may be advantageously carried out under conditions for converting a mixture of a raw material containing a metal element into an oxide for thermoelectric conversion material, and the calcination temperature and calcination atmosphere may be appropriately set. The calcination may be advantageously carried out, for example, under conditions of atmospheric air, calcination temperature: 600°C to 1500°C and holding time of calcination temperature: 0.5 to 24 hours. By this calcination, uniformity in the composition and uniformity in the structure of the resultant thermoelectric conversion material (sintered body) are improved, deformation of the thermoelectric conversion material (sintered body) is suppressed, and a thermoelectric conversion material excellent in mechanical strength is obtained. The oxide for thermoelectric conversion material obtained by calcination usually is powdery.

The formation may advantageously be carried out by uniaxial press, cold isostatic press (CIP), mechanical press, hot press, hot isobaric press (HIP) and the like. In formation, if necessary, a binder, dispersant and releasing agent may be used. The resultant green body usually has a shape of plate, circular cylinder or rectangular cylinder.

The sintering is carried out under conditions of atmosphere: air, sintering temperature: not less than 800°C and not more than 1700°C, preferably not less than 1100°C and not more than 1600°C, further preferably not less than 1200°C and not more than 1600°C, sintering time (holding time of sintering temperature): 0.5 to 48 hours.

According to the above-described production method, a sintered body (thermoelectric conversion material) having a relative density of not less than 70%, preferably not less than 80%, more preferably not less than 90% is usually obtained. In this production method, the relative density of the sintered body can be controlled by changing the particle size of a mixture of a metal compound, the particle size of a mixture of an oxide for thermoelectric conversion material and an inorganic substance, the particle size of a calcined body (powder) of a mixture, the molding pressure, the sintering temperature and the sintering time. The sintered body may be pulverized, and further, the resultant pulverized body may be sintered. The sintering may be advantageously carried out under the same conditions as for the step (a2). The sintered body may be coated with an oxygen-impermeable film. The coating is advantageously carried out, for example, using a material such as alumina, titania, zirconia and silicon carbide by aerosol deposition, thermal spraying or CVD. A thermoelectric conversion material obtained by coating the sintered body has a surface which is not easily oxidized or reduced, and shows a tendency of scarce reduction in performance.

The thermoelectric conversion material may also be produced by a method other than those described above. Examples of the other production method include a method including a co-precipitation step, a hydrothermal step, a dry up step, a sputtering step, a step of CVD, a sol gel step, a FZ (floating zone melting) step, and a step of TSCG (template type single crystal growth).

Embodiments (thermoelectric conversion material containing $CaMnO_3$, NiO)

A thermoelectric conversion material containing $CaMnO_3$, NiO may advantageously be produced, for example, by a method including a step of forming a mixture of $CaMnO_3$ and NiO to obtain a green body (corresponding to the step (a1) described above), and a step of sintering the green body in air (corresponding to the step (a2) described above). The mixture of $CaMnO_3$ and NiO is preferably prepared by a method including a step (corresponding to step (i)) in which NiO and a mixture of metal compounds which can be converted by calcination into $CaMnO_3$ are mixed and

the resultant mixture is calcined. The calcination may be advantageously carried out under conditions of atmosphere: air, calcination temperature: 600°C to 1500°C and holding time of calcination temperature: 0.5 to 24 hours. From the standpoint of obtaining a thermoelectric conversion material of high electric conductivity ($\sigma$), the sintering temperature is not less than 800°C, preferably not less than 1100°C, more preferably not less than 1200°C. From the standpoint of obtaining a thermoelectric conversion material of high figure of merit (Z) while suppressing deposition of heterogeneous phase, abnormal grain growth and melting, the sintering temperature is not more than 1700°C, preferably not more than 1600°C. The sintering time is for example 0.5 to 48 hours. The sintering atmosphere is preferably an oxygen-containing atmosphere. By changing the oxygen concentration, the amount of oxygen in a thermoelectric conversion material is controlled. In the case of use of a thermoelectric conversion device containing a thermoelectric conversion material in air at high temperature, sintering is preferably carried out in air.

### Thermoelectric conversion device

The thermoelectric conversion device of the present invention contains the above-described thermoelectric conversion material. The thermoelectric conversion device usually contains a p-type thermoelectric conversion material and an n-type thermoelectric conversion material, the p-type thermoelectric conversion material and the n-type thermoelectric conversion material being connected, and either one of the p-type thermoelectric conversion material or the n-type thermoelectric conversion material is the above-described thermoelectric conversion material. The thermoelectric conversion device has as structure, for example, described in JP-A 5-315657.

### Method of improving strength of thermoelectric conversion material

The method of improving the strength of a thermoelectric conversion material of the present invention includes a step (b1) of forming a mixture of a thermoelectric conversion material and an inorganic substance to obtain a green body.

The thermoelectric conversion material is composed of an oxide for p-type thermoelectric conversion material or oxide for n-type thermoelectric conversion material. Examples of the oxide for p-type thermoelectric conversion material include $NaCo_2O_4$, $Ca_3Co_4O_9$, Li-doped NiO, $ACuO_{2+\delta}$ (A is at least one selected from among Y, alkaline earth metal elements and rare earth metal elements, and $\delta$ is not less than 0 and not more than 1.), $RBa_2Cu_3O_{7-\delta}$ (R is at least one selected from among Y, Ce, Nd, Pm, Sm, Eu, Gd, Tb, Dy, Ho, Er, Tm, Yb and Lu , and $\delta$ is not less than 0 and not more than 1.), $(Ca, Sr)_{14}Cu_{24}O_{41}$, $(La, Sr)_2ZnO_4$ and $SrFeO_3$. Examples of the oxide for n-type thermoelectric conversion material include $SrTiO_3$, manganese oxides, $LaNiO_3$, $La_{n+1}Ni_nO_{3n+1}$ (n is an integer of 1 to 10), $(ZnO)_mIn_2O_3$ (m is an integer of 1 to 19), $(ZnO)_mInGaO_3$ (m is an integer of 1 to 19) and $Ae_xTi_8O_{16}$ (Ae is an alkaline earth metal, and x is not less than 0.8 and not more than 2.). The oxide for thermoelectric conversion material is preferably a manganese oxide such as $CaMnO_3$, $Ca_{n+1}Mn_nO_{3n+1}$ (n is an integer of 1 to 10), $CaMn_7O_{12}$, $Mn_3O_4$, $MnO_2$ and $CuMnO_2$, more preferably a calcium manganese oxide. The oxide for thermoelectric conversion material has preferably a perovskite crystal structure or layered perovskite crystal structure. Examples of the oxide for thermoelectric conversion material having a perovskite crystal structure include oxides composed mainly of $CaMnO_3$, and a part of Ca and/or Mn may be substituted by a heterogeneous element. Examples of the element for substituting for Ca include Mg, Sr, Ba, Sc, Y, La, Ce, Pr, Nd, Pm, Sm, Eu, Gd, Tb, Dy, Ho, Er, Tm, Yb, Lu, Bi, Sn, In, Pb, preferably Mg, Sr, Ba. These may be used singly or in combination with another or more. Examples of the element for substituting for Mn include Ru, Nb, Mo, W, Ta. These may be used singly or in combination with another or more. Examples of the oxide for thermoelectric conversion material having a layered perovskite crystal structure include oxides composed mainly of a compound of the formula (1):

$$Ca_{n+1}Mn_nO_{3n+1} \qquad (1)$$

n is an integer of 1 to 10, and a part of Ca and/or Mn may be substituted by a heterogeneous element. Examples of the element for substituting for Ca include Mg, Sr, Ba, Sc, Y, La, Ce, Pr, Nd, Pm, Sm, Eu, Gd, Tb, Dy, Ho, Er, Tm, Yb, Lu, Bi, Sn, In, Pb, preferably Mg, Sr, Ba. These may be used singly or in combination with another or more. Examples of the element for substituting for Mn include Ru, Nb, Mo, W, Ta. These may be used singly or in combination with another or more.

Examples of the inorganic substance include non-oxide materials such as carbides (silicon carbide, titanium carbide, boron carbide) and nitrides (silicon nitride, boron nitride), and oxide materials such as mixed oxides (binary oxides, ternary oxide), simple oxides (unitary oxides) and acid nitrides, preferably oxide materials. The oxide materials are preferably simple oxides. The simple oxides include titanium oxide, manganese oxide, cobalt oxide, nickel oxide, copper oxide, zinc oxide, zirconium oxide, niobium oxide, molybdenum oxide, aluminum oxide, silicon oxide, gallium oxide, indium oxide and tin oxide. For example, when the oxide for thermoelectric conversion material is a manganese oxide, the inorganic substance is preferably nickel oxide, copper oxide, zinc oxide, more preferably nickel oxide, copper oxide. These may be used singly or in combination with another or more. When, the inorganic substance is zinc oxide, a part of zinc may be substituted by a heterogeneous element, and examples of the element for substituting for zinc include Mg, Ca, Sr, Ba, Sc, Y, La, Ce, Pr, Nd, Sm, Eu, Gd, Tb, Dy, Ho, Er, Tm, Yb, Lu, Al, Ga, In, Ge, Sn, Ti, Zr, Hf, V, Nb, Ta, Cr, Mo, W, Mn, Fe, Co, Ni, Cu, Ru, preferably Y, La, Ce, Pr, Nd, Sm, Eu, Gd, Tb, Dy, Ho, Er, Tm, Yb, Lu, Al, Ga, In. These may be used singly or in combination with another or more. The amount of substitution is usually 0.01 mol% to 10 mol% with respect to zinc.

The formation may advantageously be carried out by uniaxial press, cold isostatic press (CIP), mechanical press, hot press, hot isobaric press (HIP) and the like. In formation, if necessary, a binder, dispersant and releasing agent may be used. The resultant green body usually has a shape of plate, circular cylinder or rectangular cylinder.

The method of improving the strength of a thermoelectric conversion material includes a step (b2) of sintering the green body obtained in the step (b1).

The sintering may be advantageously carried out, for example, under conditions of atmosphere: air, sintering temperature: not less than 800°C and not more than 1700°C, preferably not less than 1100°C and not more than 1600°C, further preferably not less than 1200°C and not more than 1600°C, sintering time (holding time of sintering temperature): 0.5 to 48 hours.

EXAMPLES

The present invention will be illustrated further in detail by examples. The properties and crystal structure of a thermoelectric conversion materials were determined by the following methods.

Electric conductivity ($\sigma$, S/m)

A thermoelectric conversion material was processed to prepare a rectangular cylindrical specimen, and a platinum line was provided on the specimen using a silver paste, and the electric conductivity was measured by a direct current four-point probe method. The measurement was carried out in a nitrogen gas flow at 673 K and 1073 K.

Seebeck coefficient ($\alpha$, $\mu$V/K)

A R thermocouple (composed of a pair of platinum-rhodium line and platinum line) was provided on the both end surfaces of a specimen having the same shape as used in electric conductivity measurement, using a silver paste, and the temperatures of the both end surfaces and the thermal electromotive force were measured. The measurement was carried out in a nitrogen gas flow at 673 K and 1073 K. A glass tube through which air was flowing was brought into contact with one end surface of the specimen to make a low temperature part, the temperatures of the both end surfaces were measured by the R thermocouple, and simultaneously, the thermal electromotive force ($\Delta V$) generated between the both end surfaces of the specimen was measured by a platinum line. The temperature difference ($\Delta T$) between the both ends of the specimen was controlled in the range of 1 to 10°C by controlling the flow rate of air flowing through the glass tube. The Seebeck coefficient ($\alpha$) was calculated from inclinations of $\Delta T$ and $\Delta V$.

Power factor (PF)

PF was calculated according to the following equation from the electric conductivity (o) and Seebeck coefficient ($\alpha$).

$$PF = \alpha^2 \times \sigma$$

Crystal structure

A sample (thermally treated body, sintered body) was analyzed by powder X-ray diffractometry using an X-ray diffractometer (trade name: RINT2500TTR, manufactured by Rigaku Corporation) with a radiation source: CuK$\alpha$.

Bending strength ($\delta_{ave}$, N/mm$^2$)

A rod-shaped specimen (sintered body) having a width (w) of $4\pm1$ mm, a thickness of (t)$3\pm1$ mm and a length of not less than 36 mm was manufactured. The specimen was subjected to three-point bending strength measurement under conditions of a length of supports (L): 30 mm, a crosshead speed: 0.5 mm/min and a measurement temperature: room temperature (25°C) using SHIKIBU manufactured by Shimadzu Corp. The bending strength ($\delta$) was calculated

according to the following equation. P is the maximum load (N) when the specimen was broken.

$$\delta = 3PL/2wt^2$$

For each sample, not less than 7 specimens were measured. The average value ($\delta_{ave}$) of residual values excepting the maximum value and the minimum value in the resultant measurement values was calculated to give a bending strength.

Example 1

[Preparation of mixture]

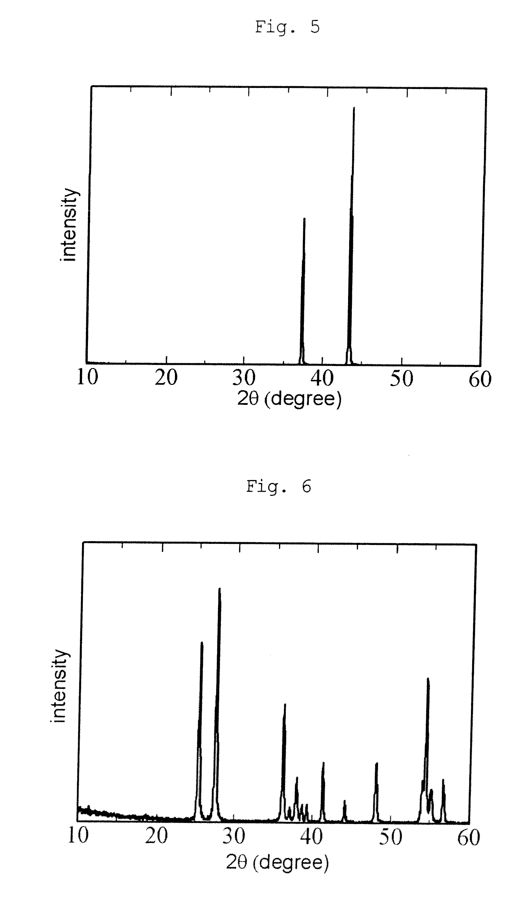

8.577 g of $CaCO_3$ (manufactured by Ube Material Industries, trade name: CS3N-A), 7.852 g of $MnO_2$ (manufactured by Kojundo Chemical Laboratory Co., Ltd.), 0.247 g of $MoO_3$ (manufactured by Kojundo Chemical Laboratory Co., Ltd.) and 2.744 g of NiO (manufactured by Kojundo Chemical Laboratory Co., Ltd., powder X-ray diffraction pattern was shown in Fig. 5) were weighed, and mixed in a wet ball mill with zirconia ball media for 20 hours to obtain a mixture. The amount of NiO was 30 mol% with respect to the resultant thermoelectric conversion material.

[Thermal treatment of mixture]

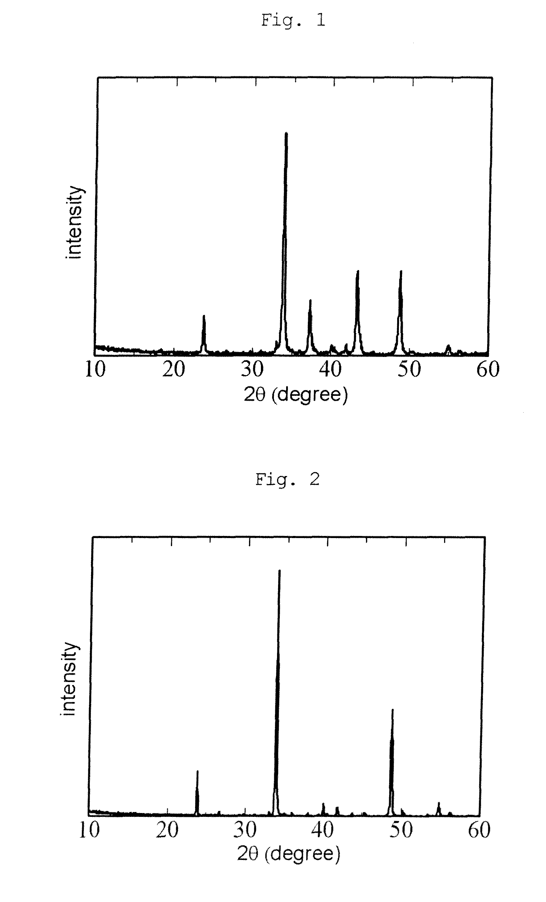

A mixture was thermally treated at atmospheric pressure in air at 900°C. The powder X-ray diffraction pattern of the resultant thermally treated body was shown in Fig. 1. Fig. 1 showed the presence of a diffraction peak ascribable to the crystal structure of $CaMn_{0.98}Mo_{0.02}O_3$ and a diffraction peak ascribable to the crystal structure of NiO, and the absence of peaks other than them.

[Forming and sintering of mixture]

A mixture was calcined in air at 900°C for 10 hours, then, the calcined body was pulverized in a wet ball mill with zirconia ball media for 20 hours to obtain a mixed powder. The mixed powder was formed by a uniaxial press (forming pressure: 500 kg/cm$^2$) to obtain a rod-shaped green body. The green body was sintered in air at 1300°C for 10 hours to obtain a sintered body 1 (thermoelectric conversion material).
The sintered body 1 had a Seebeck coefficient measured at 673 K of -153($\mu$V/K), an electric conductivity of $6.1 \times 10^2$ (S/m), and a power factor (PF) of $1.4 \times 10^{-4}$ (W/mK$^2$). The sintered body 1 had a bending strength ($\delta$) of 4.5 N/mm$^2$.

Example 2

The same operations as for [Preparation of mixture] and [Forming and sintering] in Example 1 were carried out excepting that the amount of NiO was changed to 40 mol% (NiO amount: 4.269 g) with respect to the thermoelectric conversion material to obtain a sintered body 2. The measurement results of the resultant sintered body 2 were shown in Table 1.
On the mixture of this example, the same operation as for [Thermal treatment of mixture] in Example 1 was carried out. The powder X-ray diffraction pattern of the thermally treated body showed the presence of a diffraction peak ascribable to the crystal structure of $CaMn_{0.98}Mo_{0.02}O_3$ and a diffraction peak ascribable to the crystal structure of NiO, and the absence of peaks other than them, like in Example 1.

Example 3

The same operations as for [Preparation of mixture] and [Forming and sintering of mixture] in Example 1 were carried out excepting that the amount of NiO was changed to 50 mol% (NiO amount: 6.403 g) with respect to the thermoelectric conversion material, to obtain a sintered body 3. The measurement results of the sintered body 3 were shown in Table 1.
On the mixture of this example, the same operation as for [Thermal treatment of mixture] in Example 1 was carried out. The powder X-ray diffraction pattern of the thermally treated body showed the presence of a diffraction peak ascribable to the crystal structure of $CaMn_{0.98}Mo_{0.02}O_3$ and a diffraction peak ascribable to the crystal structure of NiO, and the absence of peaks other than them, like in Example 1.

Comparative Example 1

The same operations as for [Preparation of mixture] and [Forming and sintering of mixture] in Example 1 were carried out excepting that the amount of NiO was changed to 0 mol% (NiO amount: 0 g) with respect to the thermoelectric conversion material, to obtain a sintered body 4. The measurement results of the sintered body 4 were shown in Table 1. The X-ray diffraction pattern of the sintered body 4 was shown in Fig. 2.

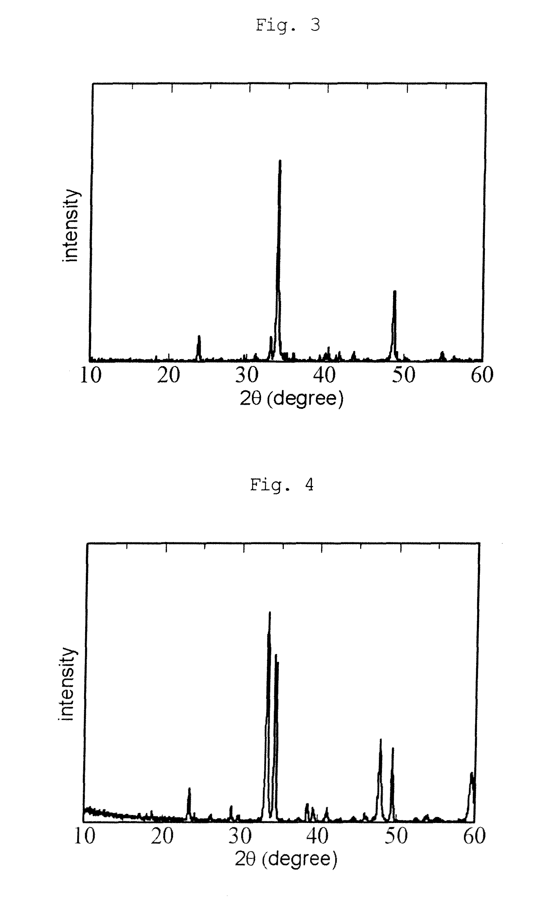

On the mixture of this example, the same operation as for [Thermal treatment of mixture] in Example 1 was carried out. The X-ray diffraction pattern of the thermally treated body was shown in Fig. 3.

Comparative Example 2

The same operations as for [Preparation of mixture] and [Forming and sintering of mixture] in Example 1 were carried out excepting that 4.564 g of $TiO_2$ (manufactured by Ishihara Techno Corporation, trade name: PT-401M, powder X-ray diffraction pattern was shown in Fig. 6) was used instead of NiO, to obtain a sintered body 5. The measurement results of the sintered body 5 were shown in Table 1.

On the mixture of this example, the same operation as for [Thermal treatment of mixture] in Example 1 was carried out. The X-ray diffraction pattern of the thermally treated body was shown in Fig. 4. Fig. 4 showed the presence of a peak (diffraction peak A) which corresponds neither to a diffraction peak ascribable to the crystal structure of $CaMn_{0.98}Mo_{0.02}O_3$ nor to a diffraction peak ascribable to the crystal structure of $TiO_2$. The diffraction peak A corresponds also to the diffraction peak (diffraction peak B) showing the maximum intensity in the powder X-ray diffraction pattern of Fig. 4. If the intensity of the diffraction peak B is 100, then, the intensity of the diffraction peak A is 100, thus, the combination of $CaMn_{0.98}Mo_{0.02}O_3$ and $TiO_2$ was a combination manifesting reaction.

Example 4

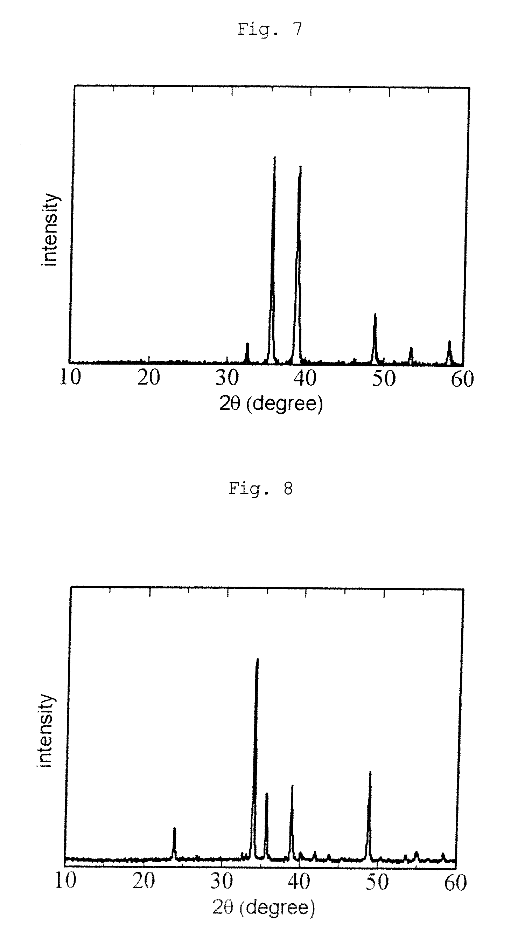

The same operations as for [Preparation of mixture] and [Forming and sintering of mixture] in Example 1 were carried out excepting that 4.545 g of CuO (manufactured by Kojundo Chemical Laboratory Co., Ltd., powder X-ray diffraction pattern was shown in Fig. 7) was used instead of NiO and the sintering temperature was changed to 1050°C to obtain a sintered body 6. The measurement results of the sintered body 6 were shown in Table 1. The amount of CuO was 40 mol% with respect to the thermoelectric conversion material.

On the mixture of this example, the same operation as for [Thermal treatment of mixture] in Example 1 was carried out. The X-ray diffraction pattern of the thermally treated body was shown in Fig. 8. Fig. 8 showed the presence of a diffraction peak ascribable to the crystal structure of $CaMn_{0.98}Mo_{0.02}O_3$ and a diffraction peak ascribable to the crystal structure of CuO, and the absence of peaks other than them.

Example 5

The same operations as in Example 4 were carried out excepting that the amount of CuO was changed to 10 mol% (CuO amount: 0.757 g) with respect to the thermoelectric conversion material, to obtain a sintered body 7. The measurement results of the sintered body 7 were shown in Table 1.

On the mixture of this example, the same operation as in Example 4 was carried out to obtain a thermally treated body. The X-ray diffraction pattern of the thermally treated body showed the presence of a diffraction peak ascribable to the crystal structure of $CaMn_{0.98}Mo_{0.02}O_3$ and a diffraction peak ascribable to the crystal structure of CuO, and the absence of peaks other than them.

Example 6

The same operations as in Example 4 were carried out excepting that the amount of CuO was changed to 5 mol% (CuO amount: 0.359 g) with respect to the thermoelectric conversion material to obtain a sintered body 8. The measurement results of the sintered body 8 were shown in Table 1. The results when measured at 1073 K were shown in Table 2.

On the mixture of this example, the same operation as in Example 4 was carried out to obtain a thermally treated body. The X-ray diffraction pattern of the thermally treated body showed the presence of a diffraction peak ascribable to the crystal structure of $CaMn_{0.98}Mo_{0.02}O_3$ and a diffraction peak ascribable to the crystal structure of CuO, and the absence af peaks other than them.

Example 7

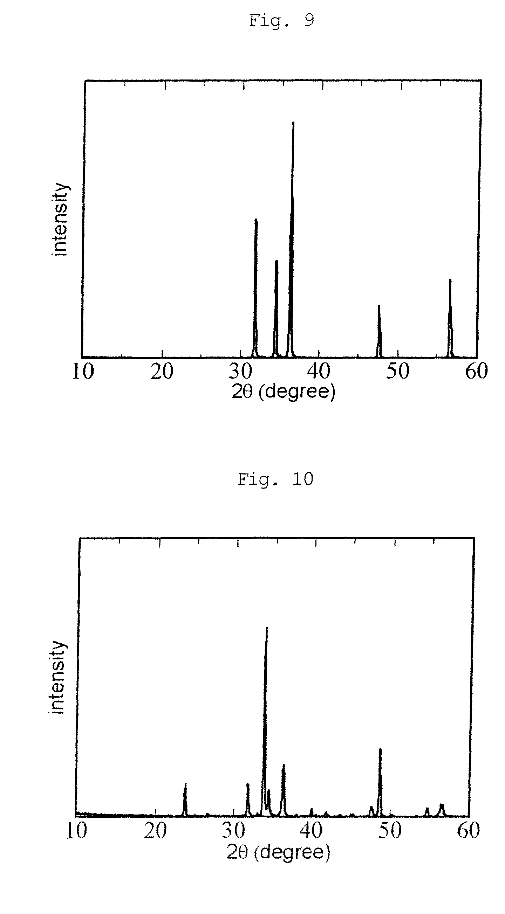

The same operations as for [Preparation of mixture] and [Forming and sintering of mixture] in Example 1 were carried out excepting that 4.649 g of ZnO(manufactured by Kojundo Chemical Laboratory Co., Ltd., powder X-ray diffraction pattern was shown in Fig. 9) was used instead of NiO to obtain a sintered body 9. The measurement results of the sintered body 9 were shown in Table 1. The amount of ZnO was 40 mol% with respect to the thermoelectric conversion material.

On the mixture of this example, the same operation as for [Thermal treatment of mixture] in Example 1 was carried out. The X-ray diffraction pattern of the thermally treated body was shown in Fig. 10. Fig. 10 showed the presence of a diffraction peak ascribable to the crystal structure of $CaMn_{0.98}Mo_{0.02}O_3$ and a diffraction peak ascribable to the crystal structure of ZnO, and the absence of peaks other than them.

Example 8

The same operations as for [Preparation of mixture] and [Forming and sintering of mixture] in Example 1 were carried out excepting that the raw materials were changed to 8.997 g of $CaCO_3$ (manufactured by Ube Material Industries, CS3N-A (trade name)), 10.505 g of $MnO_2$ (manufactured by Kojundo Chemical Laboratory Co., Ltd.), 4.192 g of $Dy_2O_3$ (manufactured by Nippon Yttrium Co., Ltd.) and 0.447 g of CuO (manufactured by Kojundo Chemical Laboratory Co., Ltd.) and the sintering temperature was changed to 1080°C to obtain a sintered body 10. The measurement results of the sintered body 10 were shown in Table 1. The amount of CuO was 5 mol% with respect to the thermoelectric conversion material.

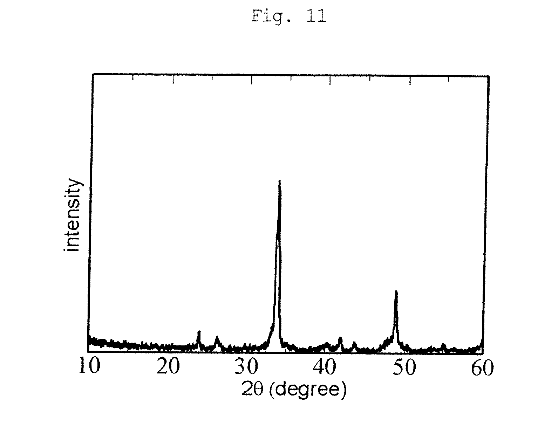

On the mixture of this example, the same operation as for [Thermal treatment of mixture] in Example 1 was carried out. The X-ray diffraction pattern of the thermally treated body was shown in Fig. 11. Fig. 11 showed the presence of a diffraction peak ascribable to the crystal structure of $CaMn_{0.98}Mo_{0.02}O_3$ and a diffraction peak ascribable to the crystal structure of CuO, and the absence of peaks other than them.

Table 1 Properties of thermoelectric conversion material

|  |  | Seebeck coefficient $\alpha$(673 K) | electric conductivity $\sigma$ (673 K) | power factor PF (673 K) | bending strength $\delta_{ave}$ |
|---|---|---|---|---|---|
|  |  | $\mu$V/K | S/m | W/mK$^2$ | N/mm$^2$ |
| Example 1 | sintered body 1 | -153 | $6.1 \times 10^2$ | $1.4 \times 10^{-4}$ | 4.5 |
| Example 2 | sintered body 2 | -137 | $5.3 \times 10^3$ | $1.0 \times 10^{-4}$ | 14.8 |
| Example 3 | sintered body 3 | -173 | $3.9 \times 10^3$ | $1.2 \times 10^{-4}$ | 15.2 |
| Comparative Example 1 | sintered body 4 | -139 | $4.9 \times 10^3$ | $9.5 \times 10^{-5}$ | 2.9 |
| Comparative Example 2 | sintered body 5 | -102 | $1.4 \times 10^1$ | $1.5 \times 10^{-7}$ | - |
| Example 4 | sintered body 6 | -120 | $7.7 \times 10^3$ | $1.1 \times 10^{-4}$ | 18.1 |
| Example 5 | sintered body 7 | -146 | $8.2 \times 10^3$ | $1.7 \times 10^{-4}$ | 16.7 |
| Example 6 | sintered body 8 | -150 | $1.1 \times 10^4$ | $2.5 \times 10^{-4}$ | 16.9 |
| Example 7 | sintered body 9 | -150 | $4.1 \times 10^3$ | $9.2 \times 10^{-5}$ | 10.7 |
| Example 8 | sintered body 10 | -70 | $1.9 \times 10^4$ | $9.3 \times 10^{-5}$ | 9.1 |

Table 2 Properties of thermoelectric conversion material

|  |  | Seebeck coefficient $\alpha$ (1073 K) | electric conductivity $\sigma$ (1073 K) | power factor PF (1073 K) |
|---|---|---|---|---|
|  |  | $\mu$V/K | S/m | W/mK$^2$ |
| Example 6 | sintered body 8 | -175 | $1.3 \times 10^4$ | $2.9 \times 10^{-4}$ |

Industrial Applicability

According to the present invention, a thermoelectric conversion material having an excellent thermoelectric conversion property and excellent in mechanical strength is provided. A thermoelectric conversion device having this thermoelectric conversion material can be suitably used for thermoelectric conversion power generation utilizing factory waste heat, incinerator waste heat, industrial furnace waste heat, automobile waste heat, ground heat, solar heat and the like, and further, can also be used in a precise temperature controlling apparatus for laser diode and the like, an air conditioning apparatus, a refrigerator and the like.

**Claims**

1. A thermoelectric conversion material comprising an oxide for thermoelectric conversion material and an inorganic substance wherein the inorganic substance does not react with the oxide for thermoelectric conversion material under conditions of pressure: 950 hPa to 1050 hPa and temperature: 900°C.

2. A thermoelectric conversion material comprising an oxide for thermoelectric conversion material and an inorganic substance wherein the material does not comprise a reaction product of the oxide for thermoelectric conversion material and the inorganic substance

3. The thermoelectric conversion material according to Claim 1 or 2 wherein the oxide for thermoelectric conversion material is a manganese oxide.

4. The thermoelectric conversion material according to Claim 3 wherein the oxide for thermoelectric conversion material is a calcium manganese oxide.

5. The thermoelectric conversion material according to Claim 1 or 2 wherein the oxide for thermoelectric conversion material has a perovskite crystal structure or layered perovskite crystal structure.

6. The thermoelectric conversion material according to Claim 1 or 2 wherein the inorganic substance is an oxide.

7. The thermoelectric conversion material according to Claim 6 wherein the inorganic substance is at least one selected from among nickel oxide, copper oxide and zinc oxide.

8. The thermoelectric conversion material according to Claim 1 or 2 wherein the amount of the inorganic substance is 1 to 60 mol% with respect to the thermoelectric conversion material.

9. The thermoelectric conversion material according to Claim 1 or 2 wherein the form of the material is sintered body and the sintered body has a relative density of not less than 70%.

10. A thermoelectric conversion device comprising the thermoelectric conversion material as described in Claim 1 or 2.

11. A method for producing a thermoelectric conversion material comprising the steps (a1) and (a2):

    (a1) forming a mixture of an oxide for thermoelectric conversion material and an inorganic substance to obtain a green body,
    (a2) sintering the green body in air at 800°C to 1700°C.

12. The method according to Claim 11, further comprising a step (a0) selected from among (i) and (ii), for preparing a mixture an oxide for thermoelectric conversion material and an inorganic substance:

    (i) calcining a mixture of a raw material containing a metal element which is converted by calcination into an oxide for thermoelectric conversion material, and an inorganic substance,
    (ii) calcining a raw material containing a metal element which is converted by calcination into an oxide for thermoelectric conversion material, and mixing the resultant calcined body and an inorganic substance.

13. The method according to Claim 12 wherein the calcination is carried out in air at 600°C to 1500°C.

**14.** A method of improving the strength of a thermoelectric conversion material, comprising the steps (b1) and (b2):

(b1) forming a mixture of a thermoelectric conversion material and an inorganic substance to obtain a green body,
(b2) sintering the green body in air at 800°C to 1700°C.

Fig. 1

Fig. 2

Fig. 3

Fig. 4

Fig. 5

Fig. 6

Fig. 7

Fig. 8

Fig. 9

Fig. 10

Fig. 11

<div align="center">

**INTERNATIONAL SEARCH REPORT**

</div>

| | International application No. |
|---|---|
| | PCT/JP2007/070388 |

**A. CLASSIFICATION OF SUBJECT MATTER**
*H01L35/22(2006.01)i, C04B35/00(2006.01)i, H01L35/34(2006.01)i*

According to International Patent Classification (IPC) or to both national classification and IPC

**B. FIELDS SEARCHED**

Minimum documentation searched (classification system followed by classification symbols)
H01L35/22, C04B35/00, H01L35/34

Documentation searched other than minimum documentation to the extent that such documents are included in the fields searched
Jitsuyo Shinan Koho          1922-1996   Jitsuyo Shinan Toroku Koho   1996-2008
Kokai Jitsuyo Shinan Koho    1971-2008   Toroku Jitsuyo Shinan Koho   1994-2008

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 11-097751 A  (Daiken Chemical Co., Ltd.), 09 April, 1999 (09.04.99), Claims; Par. Nos. [0037], [0049] (Family: none) | 1 |
| Y | JP 2004-214244 A  (Japan Ultra-high Temperature Materials Research Institute), 29 July, 2004 (29.07.04), Claims; Par. Nos. [0001], [0020] to [0021] (Family: none) | 1 |
| Y | JP 2005-223237 A  (Japan Ultra-high Temperature Materials Research Institute), 18 August, 2005 (18.08.05), Claims 1, 2; Par. No. [0001] (Family: none) | 1 |

☒ Further documents are listed in the continuation of Box C.          ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 07 January, 2008 (07.01.08) | 15 January, 2008 (15.01.08) |

| Name and mailing address of the ISA/ Japanese Patent Office | Authorized officer |
|---|---|
| Facsimile No. | Telephone No. |

Form PCT/ISA/210 (second sheet) (April 2007)

**INTERNATIONAL SEARCH REPORT**

| International application No. |
|---|
| PCT/JP2007/070388 |

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 6-302866 A  (Idemitsu Materials Co., Ltd.),<br>28 October, 1994 (28.10.94),<br>Claims 1, 2; Par. No. [0003]<br>(Family: none) | 1 |
| Y | JP 2006-278997 A  (Toyota Central Research and Development Laboratories, Inc.),<br>12 October, 2006 (12.10.06),<br>Par. No. [0069]<br>(Family: none) | 1 |

Form PCT/ISA/210 (continuation of second sheet) (April 2007)

**INTERNATIONAL SEARCH REPORT**

International application No.

PCT/JP2007/070388

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
    because they relate to subject matter not required to be searched by this Authority, namely:

2. ☐ Claims Nos.:
    because they relate to parts of the international application that do not comply with the prescribed requirements to such an extent that no meaningful international search can be carried out, specifically:

3. ☐ Claims Nos.:
    because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:
    See extra sheet.

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.:
    Claim 1

**Remark on Protest**
the

☐ The additional search fees were accompanied by the applicant's protest and, where applicable, payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

| **INTERNATIONAL SEARCH REPORT** | International application No. |
|---|---|
| | PCT/JP2007/070388 |

Continuation of Box No.III of continuation of first sheet(2)

An international application complies with the requirement of unity of invention (Rule 13.1 of the Regulations under the PCT) only when there is a technical relationship, among the group of the subject matters claimed in the claims, which involves one or more, identical or corresponding special technical features (technical features clearly showing a contribution made by the subject matters as a whole to the prior art), as provided for in Rule 13.2 of the Regulations under the PCT.

In this application, the subject matter of claim 1 relates to "one in which the inorganic substance does not react with the oxide for thermo-electric converting materials under the conditions of a pressure of 950-1,050 hPa and a temperature of 900°C."
On the other hand, the subject matter of claim 2 relates to "a thermo-electric converting material which does not contain any reaction product formed by a reaction between the oxide for thermo-electric converting materials and the inorganic substance." That is, the subject matter of claim 2 involves, e.g., a thermo-electric converting material which has <u>not</u> undergone a treatment under the conditions of a pressure of 950-1,050 hPa and a temperature of 900°C and hence does not contain the "reaction product," although the inorganic substance <u>reacts</u> with the oxide for thermo-electric converting materials under such pressure and temperature conditions.

In view of this, it is not considered that there is a technical relationship between the subject matter of claim 1 and the subject matter of claim 2 (and that part of claims 3-10 in which claim 2 is cited) which involves one or more, identical or corresponding special technical features.

A comparison between the subject matter of claim 1 and the subject matters of claims 11-14 shows the following. Claims 11-14 include no statement as to whether the inorganic substance reacts with the oxide for thermo-electric converting materials. In view of this, it cannot be considered that there is a technical relationship between the subject matters of claims 11-14 and the subject matter of claim 1, in which "the inorganic substance does not react with the oxide for thermo-electric converting materials under the conditions of a pressure of 950-1,050 hPa and a temperature of 900°C," which involves one or more, identical or corresponding special technical features.

Furthermore, any other matters in those subject matters cannot be regarded as identical or corresponding special technical features.
(Incidentally, "a thermo-electric converting material comprising an oxide for thermo-electric converting materials and an inorganic substance," which is a technical feature common among the subject matters of claims 1-14, is described in, e.g., document (1), JP 11-097751 A. (The thermo-electric converting material of the claim 1 in the document (1) corresponds to the "oxide for thermo-electric converting materials" given in this application. The document (1) includes a statement in [0037] to the effect that the "oxide for thermo-electric converting materials" may contain gold or the like, which corresponds to the "inorganic substance" in this application.) That technical feature is considered to have been an already known technical feature at the time of the filing of this application. It is hence not regarded as a technique contributing to the prior art. Consequently, that technical feature is not considered to be the <u>special</u> technical feature as provided for in the Regulations.)

Form PCT/ISA/210 (extra sheet) (April 2007)

**INTERNATIONAL SEARCH REPORT**

| | International application No. |
|---|---|
| | PCT/JP2007/070388 |

    For these reasons, it is considered that among the subject matters in this application, there is no relationship which involves one or more, identical or corresponding special technical features. The subject matters of the claims in this international application do not comply with the requirement of unity of invention as provided for in Rule 13.1 of the Regulations under the PCT.

Form PCT/ISA/210 (extra sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 8231223 A
- JP 2003142742 A
- JP 9321346 A
- JP 2001064021 A
- JP 2001512910 A
- JP 5315657 A

**Non-patent literature cited in the description**

- *Oxide Thermoelectrics,* 2002, ISBN 81-7736-100-7, 213-234